# EUROPEAN PATENT APPLICATION

(11) **EP 4 020 787 A1**
(43) Date of publication of application: **29.06.2022**
(21) Application number: 19947717.5
(22) Date of filing: 30.09.2019
(51) Int. Cl.: H02N 2/04, H02K 7/102

(54) **BAND-TYPE BRAKE DEVICE, ROBOT JOINT, AND COLLABORATIVE ROBOT**

(71) Applicant: Siemens Ltd., China, Chaoyang District Beijing 100102 (CN)
(72) Inventor: ZHANG, Sheng, Langfang, Hebei 065000 (CN); ZHOU, Wen Juan, Beijing 100000 (CN); JIANG, Chao, Beijing 100071 (CN); YANG, Yong, Beijing 102200 (CN); LIU, Xiao Kuan, Beijing 100102 (CN)
(74) Representative: Isarpatent
(86) International application number: PCT/CN2019/109591
(87) International publication number: WO 2021/062697

(57) **Abstract**

Disclosed are a band-type brake device (100), a robot joint (600), and a collaborative robot (700). The band-type brake device (100) comprises: a piezoceramic stack (102), which is arranged extending in the direction of a first axis (XX'), wherein the piezoceramic stack is provided with a first end (1022) and a second end (1024) in the direction of the first axis (XX'), the first end (1022) and the second end (1024) of the piezoceramic stack (102) extend outwards in the direction of the first axis (XX') when the band-type brake device (100) is in an electrified state, and the first end (1022) and the second end (1024) contract inwards when power failure occurs; a displacement adjuster (104), which is arranged around the piezoceramic stack (102), and comprises a first input end (1042) and a second input end (1044) in the direction of the first axis (XX'), and a first output end (1046) and a second output end (1048) in the direction of a second axis (YY') perpendicular to the first axis (XX'); and at least one friction component (106), wherein the first end (1022) and the second end (1024) of the piezoceramic stack (102) abut against the first input end (1042) and the second input end (1044) respectively, at least one of the first output end (1046) and the second output end (1048) is connected to the friction component (106), or at least one of the first output end (1046) and the second output end (1048) is integrally formed with the friction component (106).

## Description

### Technical Field

The present disclosure generally relates to the field of mechanical technology, and more particularly, to a band-type brake device, a robot joint and a cooperative robot.

### Background Art

For safety reasons, there is a need in some applications for a band-type brake device, for example, a joint of a cooperative robot. As such, in the event of some emergency such as power failure or power train system failure, the cooperative robot can maintain an initial posture. The band-type brake device should be in a clamping status when power failure occurs and in a released status when electrified.

Meanwhile, in some cases of special use (such as medical use), an arm of the cooperative robot needs to be maintained in a correct position stably and with high accuracy, so the joint must have an accurate band-type brake.

However, the arm of the cooperative robot arm should be as lightweight as possible, and the band-type brake device should also be lightweight. Furthermore, considering the heat dissipation and energy consumption, the band-type brake device should consume low power as much as possible when released.

At present, most cooperative robots use some general solutions as described below.

In a band-type brake device in the prior art, a band-type brake disc has 4-6 teeth which are mounted on a rotor shaft and rotate about the rotor shaft. A linear coil is used as an actuator. When power failure of the linear coil occurs, a piston thereof is pushed into a gap between the two teeth of the band-type brake disc by means of a spring, and then the rotor shaft and the band-type brake disc are locked between the two teeth. When the linear coil is electrified, the piston thereof exits the gap, and then the band-type brake disc is released.

Some other cooperative robots use an electromagnetic band-type brake device, some friction blocks are arranged in a circumferential direction of the band-type brake disc, and the band-type brake disc is connected to and rotates about the rotor shaft. Two retaining discs are arranged on two sides of the band-type brake disc, one of which is fixed, and the other is pushed, in the power failure state, towards the fixed retaining disc by means of some springs in an axial direction. In the electrified state, an unfixed retaining disc is electromagnetically pulled open to form an air gap in the axial direction between the friction blocks and the two retaining discs, and then the band-type brake disc is released.

### Summary of the Invention

The brief summary of the present invention is given below to provide a basic understanding of some aspects of the present invention. It should be understood that the summary is not an exhaustive summary of the present invention. The summary is neither intended to determine the key or important part of the present invention, nor to limit the scope of the present invention. The object thereof is merely to give some concepts in a simplified form, as a prelude to the more detailed description presented later.

According to an aspect of the present disclosure, a band-type brake device is provided, comprising: a piezoceramic stack, which is arranged extending in the direction of a first axis and is provided with a first end and a second end in the direction of the first axis, wherein the first end and the second end of the piezoceramic stack extend outwards in the direction of the first axis when the band-type brake device is in an electrified state, and the first end and the second end of the piezoceramic stack contract inwards in the direction of the first axis when power failure of the band-type brake device occurs; a displacement adjuster, which is arranged around the piezoceramic stack and comprises a first input end and a second input end in the direction of the first axis, and a first output end and a second output end in the direction of a second axis perpendicular to the direction of the first axis; and at least one friction component, wherein the first end and the second end of the piezoceramic stack respectively abut against the first input end and the second input end of the displacement adjuster, at least one of the first output end and the second output end of the displacement adjuster is connected to the at least one friction component, or at least one of the first output end and the second output end of the displacement adjuster is integrally formed with the at least one friction component.

Optionally, in an example of the above aspect, the band-type brake device further comprises at least one brake arm, with a first end of the at least one brake arm being connected to at least one of the first output end and the second output end of the displacement adjuster, and a second end of the at least one brake arm being connected to the at least one friction component.

Optionally, in an example of the above aspect, the first input end and the second input end of the displacement adjuster receive input displacements from the first end and the second end of the piezoceramic stack and in the direction of the first axis, and the first output end and the second output end of the displacement adjuster magnify and output the input displacements in the direction of the second axis.

Optionally, in an example of the above aspect, the outer surface and the inner surface of the displacement adjuster are provided with recesses at appropriate positions to form hinges such that the displacement adjuster forms a connecting rod mechanism.

Optionally, in an example of the above aspect, the positions, shapes, and depths of the recesses are set according to the stress distribution requirements and rebound stiffness requirements of the displacement adjuster.

According to another aspect of the present disclosure, a robot joint is provided, comprising a band-type brake device as described above . The band-type brake device is fitted and mounted to a rotor of an electric motor in the robot joint for braking the rotor.

According to yet another aspect of the present disclosure, a cooperative robot is provided, comprising the robot joint as described above.

The band-type brake device according to the present disclosure is advantageous in that the band-type brake device is lightweight, has low energy consumption, and can be used in a non-magnetic environment.

The band-type brake device according to the present disclosure can achieve precise torque control as well as wear monitoring and compensation.

The band-type brake device according to the present disclosure has almost zero energy consumption in an operating state, and the torque force can be controlled by means of the feedback of the piezoelectric displacement.

Furthermore, since the piezoceramic stack has a high dynamic performance, the band-type brake device according to the present disclosure can operate at a high frequency.

The cooperative robot according to the present disclosure is braked in a power failure state and released in an electrified state, so that safe braking can be performed.

### Brief Description of the Drawings

The foregoing and other objectives, features, and advantages of the present invention can be more easily understood with reference to the following descriptions of embodiments of the present invention in conjunction with the accompanying drawings. Components in the accompanying drawings are merely for illustrating the principle of the present invention. In the accompanying drawings, the same or similar technical features or components are represented by using the same or similar reference signs.
Fig. 1A shows a front plan view of a schematic structure of a band-type brake device according to an embodiment of the present disclosure;
Fig. 1B shows an exploded perspective view of the schematic structure of the band-type brake device according to the embodiment of the present disclosure;
Fig. 2 shows a front plan view of a schematic structure of a band-type brake device according to another embodiment of the present disclosure;
Fig. 3A shows a front plan view of another exemplary structure of a displacement adjuster;
Fig. 3B shows a perspective view of a band-type brake device using the displacement adjuster shown in Fig. 3A;
Fig. 4A shows a perspective view of a displacement adjuster according to an embodiment of the present disclosure;
Fig. 4B shows a perspective view of a displacement adjuster according to another embodiment of the present disclosure;
Fig. 5 shows a schematic view of the band-type brake device cooperatively used with a clamping ring according to the present disclosure;
Fig. 6 is a simplified block diagram of a robot joint according to an embodiment of the present disclosure; and
Fig. 7 is a schematic view of a cooperative robot according to an embodiment of the present disclosure.

**Reference numerals**

| | | | |
|---|---|---|---|
| 100, 200: | Band-type brake device | 102, 202: | Piezoceramic stack |
| 104, 204: | Displacement adjuster | 106, 206: | Friction component |
| 1022, 2022: | First end of | 1024, 2024: | Second end of |
| | piezoceramic stack | | piezoceramic stack |
| 1042, 2042: | First input end | 1044, 2044: | Second input end |
| 1046, 2046: | First output end | 1048, 2048: | Second output end |
| XX': | First axis | YY': | Second axis |
| a, a': | Input displacement | b, b': | Output displacement |
| 208: | Brake arm | 2082: | First end of brake arm |
| 2084: | Second end of brake arm | 301: | Recess |
| 401: | Perforated mounting component | 502: | Clamping ring |
| 600: | Robot joint | 602: | Electric motor |
| 6022: | Rotor | 700: | Cooperative robot |

### Detailed Description of Embodiments

The subject matter described herein will now be discussed with reference to exemplary embodiments. It should be understood that the discussion of the embodiments is merely intended to enable those skilled in the art to better understand and realize the subject matter described herein, but not to limit the protection scope, applicability or examples set forth in the claims. The functions and arrangement of the discussed elements can be changed without departing from the protection scope of the present disclosure. Various processes or assemblies can be omitted, replaced, or added in various examples as needed. For example, the described method can be performed in an order different from the described order, and the steps can be added, omitted, or combined. In addition, the features described with respect to some examples can also be combined in other examples.

As used herein, the term "include/comprise" and the variations thereof denote an open term, which means "include/comprise but not limited to". The term "based on" denotes "at least partially based on". The terms "an embodiment" and "one embodiment" denote "at least one embodiment". The term "another embodiment" denotes "at least one other embodiment". The terms "first", "second", etc. may refer to different or the same objects. Other definitions, whether explicit or implicit, can be contained below. Unless explicitly specified in the context, the definition of a term is consistent throughout the description.

The present disclosure provides a band-type brake device based on a piezoceramic stack having a displacement adjuster. The band-type brake device can be used for a cooperative robot joint or a servo motor to achieve an accurate band-type brake.

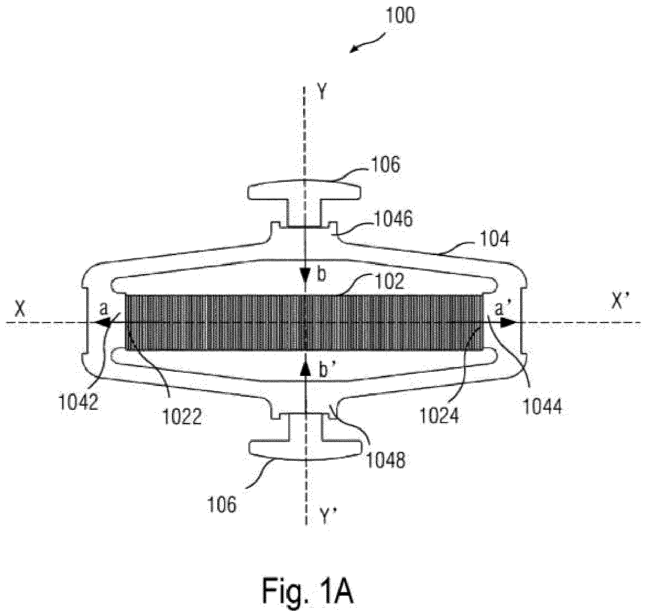

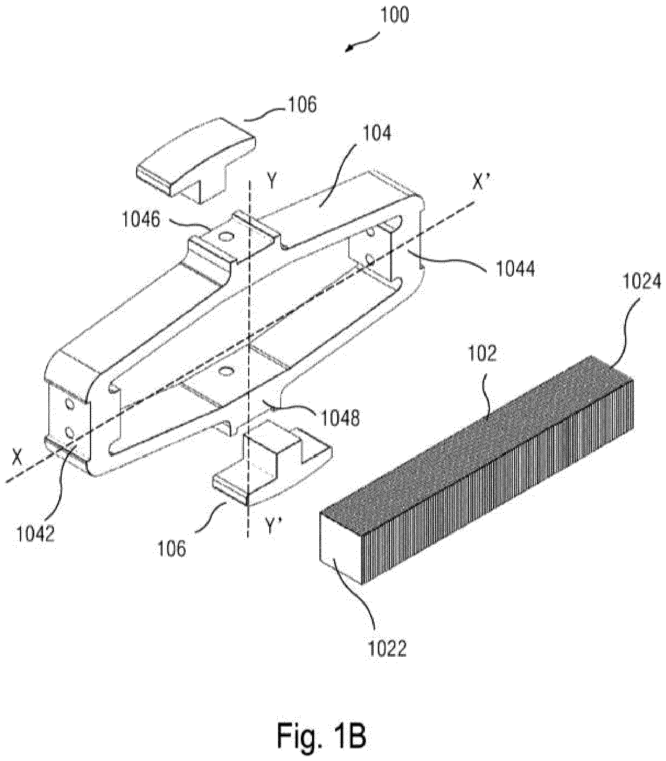

Fig. 1A shows a front plan view of a schematic structure of a band-type brake device 100 according to an embodiment of the present disclosure; Fig. 1B shows an exploded perspective view of the structure of the band-type brake device 100 according to the embodiment of the present disclosure.

As shown in Figs. 1A and 1B, the band-type brake device 100 according to the embodiment of the present disclosure comprises: a piezoceramic stack 102, a displacement adjuster 104, and at least one friction component 106.

It will be appreciated by those skilled in the art that the piezoceramic stack is composed of a plurality of stacked piezoceramic chips, and when in an electrified state, the piezoceramic stack can extend significantly more than a free stroke of a single piezoceramic chip.

In the present disclosure, the piezoceramic stack 102 is arranged extending in the direction of a first axis XX' and is provided with a first end 1022 and a second end 1024 in the direction of the first axis XX'. The first end 1022 and the second end 1024 of the piezoceramic stack 102 extend outwards in the direction of the first axis XX' when the band-type brake device 100 is in the electrified state, and the first end 1022 and the second end 1024 of the piezoceramic stack 102 contract inwards in the direction of the first axis XX' when the power failure of the band-type brake device 100 occurs.

The displacement adjuster 104 is arranged around the piezoceramic stack 102. The displacement adjuster 104 comprises a first input end 1042 and a second input end 1044 in the direction of the first axis XX', and a first output end 1046 and a second output end 1048 in the direction of a second axis YY' perpendicular to the direction of the first axis XX'.

The first end 1022 and the second end 1024 of the piezoceramic stack 102 abut against the first input end 1042 and the second input end 1044 of the displacement adjuster 104 respectively, at least one of the first output end 1046 and the second output end 1048 of the displacement adjuster 104 is connected to the at least one friction component 106, or at least one of the first output end 1046 and the second output end 1048 of the displacement adjuster is integrally formed with the at least one friction component 106.

The direction of the first axis is for example a horizontal direction, and the direction of the second axis is for example a vertical direction. It will be understood that the direction of the first axis XX' and the direction of the second axis YY' described herein are mainly intended to illustrate the positional relationship of various components of the band-type brake device, and the directions of the first axis and the second axis are not limited, for example, the direction of the first axis may also be the vertical direction, in which case the direction of the second axis is the horizontal direction.

The first input end 1042 and the second input end 1044 of the displacement adjuster 104 herein are terminals for receiving input displacements from the first end 1022 and the second end 1024 of the piezoceramic stack 102, and the first output end 1046 and the second output end 1048 are terminals for outputting the displacements.

For example, when the band-type brake device 100 is electrified, the first input end 1042 and the second input end 1044 of the displacement adjuster 104 receive the input displacements a and a' respectively towards the outer side of the displacement adjuster 104 from the first end 1022 and the second end (1024) of the piezoceramic stack 102 and in the direction of the first axis XX' , and the first output end 1046 and the second output end 1048 magnify the input displacements and output the output displacements b and b' respectively towards the inner side of the displacement adjuster 104 in the direction of the second axis YY' (see Fig. 1) ; when power failure of the band-type brake device 100 occurs, the first input end 1042 and the second input end 1044 of the displacement adjuster 104 receive the input displacements from the first end 1022 and the second end 1024 of the piezoceramic stack 102 and respectively towards the inner side of the displacement adjuster 104 in the direction of the first axis XX', and the first output end 1046 and the second output end 1048 magnify the input displacements and output the output displacements towards the outer side of the displacement adjuster 104 in the direction of the second axis YY' .

The friction component 106 is used for generating a braking force upon contact with external equipment, and may be made of a material having a high friction coefficient.

The shape and material of the friction component are not limited in the present disclosure, and an appropriate shape and material may be selected according to the requirements of the magnitude of the braking force. The manner of connecting the output end of the displacement adjuster and the friction component is also not limited, and for example, the output end of the displacement adjuster and the friction component may be fixed together by means of a screw. Furthermore, the output end of the displacement adjuster and the friction component may be integrally formed, and for example, the output end of the displacement adjuster may be directly coated with the material having the high friction coefficient to serve as the friction component.

It will be appreciated that one friction component may be connected to the two output ends 1046 and 1048 of the displacement adjuster 104 as required, and only one output end may also be connected to the friction component.

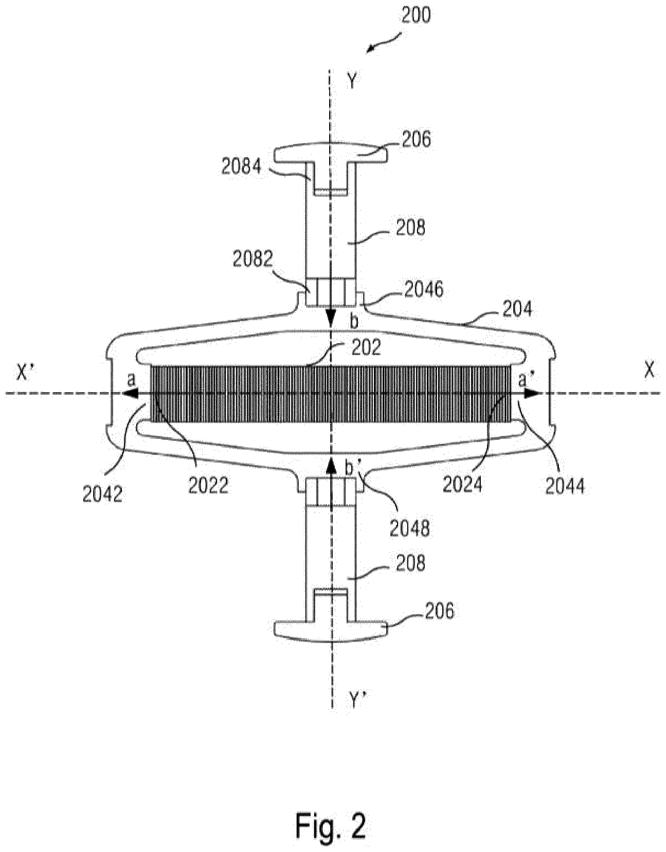

Fig. 2 shows a schematic structural view of a band-type brake device 200 according to another embodiment of the present disclosure.

In addition to the piezoceramic stack 202, the displacement adjuster 204, and the at least one friction component 206, the band-type brake device shown in Fig. 2 further comprises at least one brake arm 208.

The structures and connection relationship of the piezoceramic stack 202 and the displacement adjuster 204 are similar to those of the piezoceramic stack 102 and the displacement adjuster 104 in Fig. 1, and will not be repeatedly described herein.

In Fig. 2, a first end 2082 of the brake arm 208 is connected to an output end 2046 of the displacement adjuster 204, and a second end 2084 of the brake arm 208 is connected to the friction component 206. Specifically, the connection may be performed by means of a screw, or the first end of the brake arm may be integrally formed with the displacement adjuster and/or the second end of the brake arm may be integrally formed with the friction component. The present disclosure is not limited as to the specific manner of connecting the displacement adjuster, the brake arm, and the friction component.

It will be appreciated that the band-type brake device may comprise two brake arms, the first ends of the two brake arms are respectively connected to one of the two output ends of the displacement adjuster, and the second ends of the two brake arms are respectively connected to a friction component. The band-type brake device may also comprise only one brake arm connected to one friction component.

The size of the brake arm may be set by those skilled in the art according to the requirements in a specific application, and therefore, the size of the brake arm is not limited in the present disclosure.

In the band-type brake devices 100 and 200 shown in Figs. 1 and 2 above, optionally, the displacement adjuster may be a ring having eight faces, the ring is symmetrical about the first axis XX' and the second axis YY' respectively, the first input end and the second input end of the displacement adjuster are located on the opposite faces of the ring perpendicular to the first axis XX' , and the first output end and the second output end of the displacement adjuster are located on the opposite faces of the ring perpendicular to the second axis YY'.

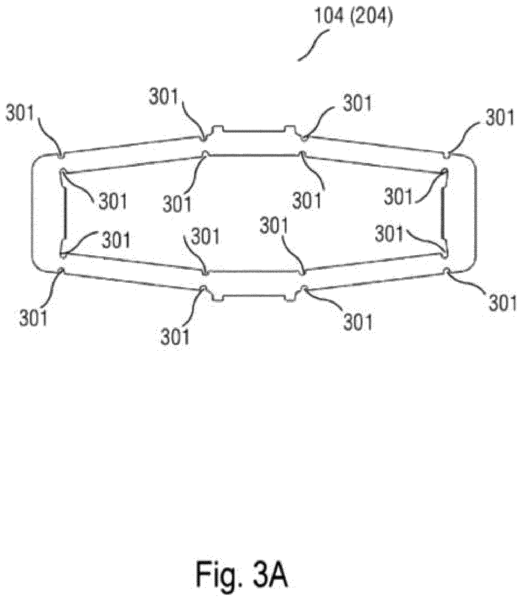

Fig. 3A shows a schematic view of another exemplary structure of the displacement adjuster that may be used in the band-type brake device of the present disclosure.

In the displacement adjuster shown in Fig. 3A, the outer and inner surfaces of the eight faces of the displacement adjuster are provided with recesses 301 at appropriate positions such that the displacement adjuster forms a connecting rod mechanism.

By providing the recesses at the appropriate positions, the positions weakened by the recesses are equivalent to hinges such that the displacement adjuster essentially forms an eight-connecting-rod mechanism, and connecting rods are connected using the hinges.

The positions, shapes, and depths of the recesses may be set according to the stress distribution requirements and rebound stiffness requirements of the displacement adjuster.

The positions and shapes of the recesses are configured to ensure that the displacement adjuster has a good stress distribution, and by adjusting the depths of the recesses, it is possible to make the displacement adjuster have a different rebound stiffness, so that displacements of different magnification times can be output for the input displacements.

Those skilled in the art may calculate suitable values of the positions, shapes and depths of the recesses according to the requirements for the magnification times of the displacement adjuster, which will not be described in detail herein.

It will be understood by those skilled in the art that the shape of the displacement adjuster according to the present disclosure, which is a ring having eight faces as described above, is for illustration only and the shape of the displacement adjuster is not limited by the present disclosure as long as it can receive the input displacement and can output the displacements in a direction perpendicular to a displacement input direction.

It may be appreciated that both the band-type brake device 100 in Fig. 1 and the band-type brake device 200 in Fig. 2 may use the structure of the displacement adjuster provided with the recesses shown in Fig. 3A such that the band-type brake device has better dynamic performance.

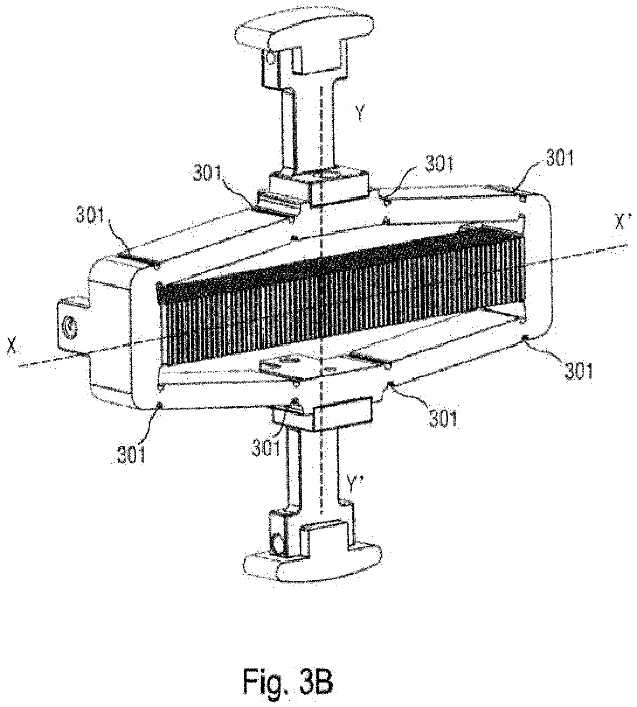

Fig. 3B shows a perspective view of the band-type brake device 200 which uses the displacement adjuster provided with the recesses 301 shown in Fig. 3A.

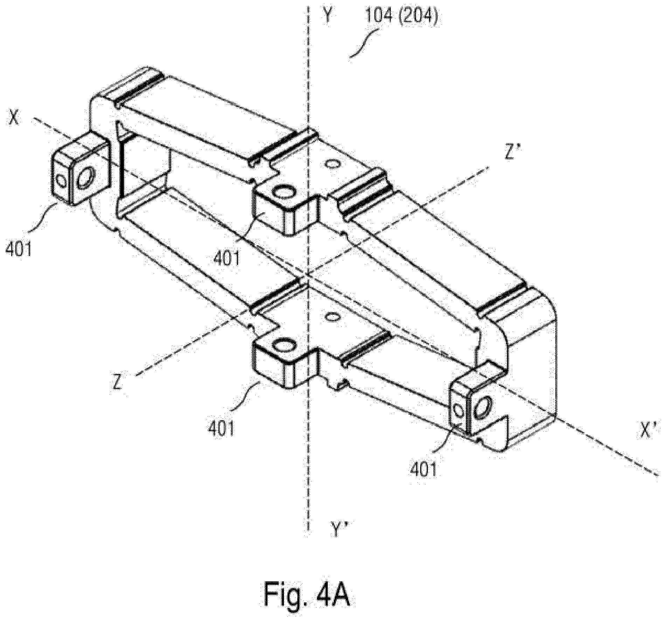

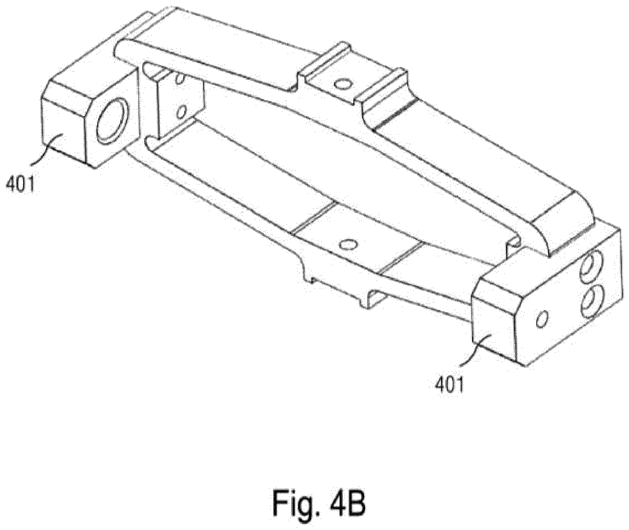

Fig. 4A shows a perspective view of a displacement adjuster according to an embodiment of the present disclosure; Fig. 4B shows a perspective view of a displacement adjuster according to another embodiment of the present disclosure.

It can be seen that the displacement adjuster is provided with a protruding perforated mounting component 401 in a ZZ' direction of a plane perpendicular to the direction of the first axis XX' and the direction of the second axis YY' , and the perforated mounting component 401 is used for fixing the band-type brake device to other equipment.

In Fig. 4A, the displacement adjuster has four perforated mounting components 401, and the perforated mounting components 401 are integrally formed with the displacement adjuster. In Fig. 4B, the displacement adjuster has two perforated mounting components 401, and the perforated mounting components in Fig. 4B are independent and assembled with the displacement adjuster, for example, by means of screws. It will be appreciated that the arrangement manner and number of the perforated mounting components of the displacement adjuster are not limited in the present disclosure.

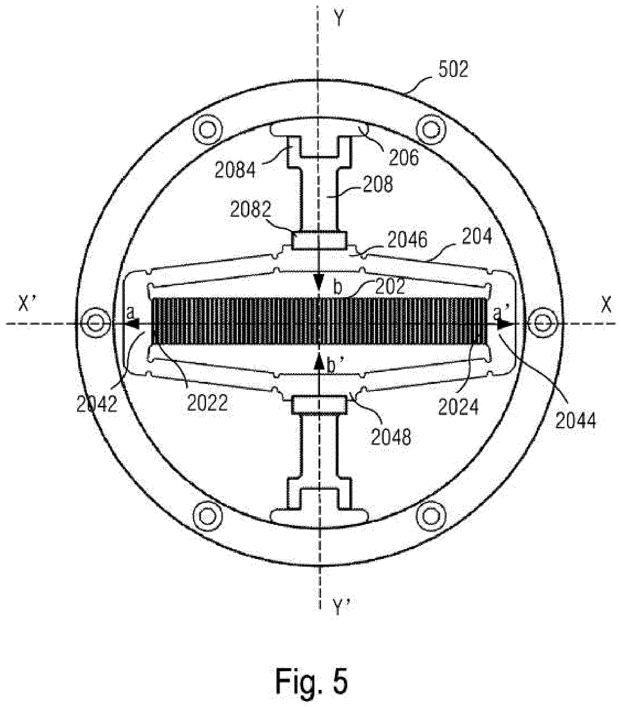

Fig. 5 shows a schematic view of the band-type brake device used in cooperation with a clamping ring according to the present disclosure.

A specific process of braking the clamping ring using the band-type brake device according to an embodiment of the present disclosure will be described in conjunction with Fig. 5.

When the band-type brake device 200 is in the electrified state, a first end 2022 and a second end 2024 of the piezoceramic stack 202 extend outwards in the first axis XX', pushing a first input end 2042 and a second input end 2044 of the displacement adjuster 204 to generate input displacements a and a' towards the outer side of the displacement adjuster 204, such that a first output end 2046 and a second output end 2048 of the displacement adjuster 204 generate output displacements b and b' respectively towards the inner side of the displacement adjuster 204, thus separating the friction component 206 from the clamping ring 502, and the band-type brake device 200 is in a released status;
when power failure of the band-type brake device 200 occurs, the first end 2022 and the second end 2024 of the piezoceramic stack 202 contract inwards in the first axis XX' , pulling the first input end 2042 and the second input end 2044 of the displacement adjuster 204 to generate input displacements respectively towards the inner side of the displacement adjuster 204, such that the first output end 2046 and the second output end 2048 of the displacement adjuster 204 generate output displacements respectively towards the outer side of the displacement adjuster 204, thus coupling the friction component 206 to the inner surface of the clamping ring 502 and generating a braking force to the clamping ring 502.

It will be appreciated by those skilled in the art that the band-type brake device according to the embodiment of the present disclosure may be used in cooperation with the clamping ring, and then generates a braking force to braked equipment such as a rotor of an electric motor by means of the clamping ring. It is also possible to use the band-type brake device directly in cooperation with other braked equipment to generate a braking force. The operating process of the band-type brake device according to the embodiment of the present disclosure is illustrated herein with reference only to Fig. 5.

Specifically, a common piezoceramic stack with a dimension of 60 mm * 10 mm * 10 mm is exemplified. An extension stroke thereof is about 0.06 mm, the maximum block force is about 3800 N, and when the extension stroke is 0.03 mm, the block force is about 1900 N. That is to say, when the piezoceramic stack is expanded at a rate of about 1/1000 in the direction of the axis XX', a large block force will be generated. This energy is sufficient to achieve a band-type brake of an electric motor in a cooperative robot joint.

In general, the piezoceramic stack can only be extended by a small stroke, which is not sufficient in view of an air gap of a coupling surface of a band-type brake. In the band-type brake device according to the present disclosure, the stroke may be increased by 4 to 10 times by adding a displacement adjuster. When a voltage is applied, the piezoceramic stack is stretched, so that the output end of the displacement adjuster is shortened, releasing the band-type brake. When power failure occurs, the piezoceramic stack is shortened to its original length and the output end of the displacement adjuster is stretched such that the friction component is coupled to the inner surface of the clamping ring, generating a braking force.

That is to say, the band-type brake device according to the present disclosure is braked in the power failure state and released in the electrified state, thus it is a safe clamping device. If the band-type brake device according to the present disclosure is used to replace the band-type brake device for an electric motor in a current cooperative robot joint, safe braking may be performed.

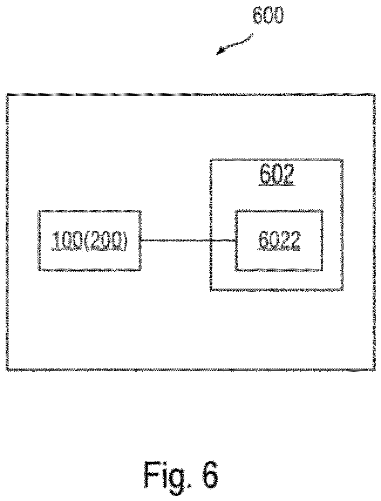

Fig. 6 is a simplified block diagram of a robot joint according to an embodiment of the present disclosure. A band-type brake device 100 or 200 according to the present disclosure is mounted in the robot joint 600 according to the embodiment of the present disclosure. The band-type brake device is fitted and mounted to the rotor 6022 of the electric motor 602 in the robot joint 600 for braking the rotor 6022.

In the robot joint 600, the band-type brake device as shown in Fig. 1 or 2 may be directly fitted and mounted to the rotor of the electric motor for braking the rotor. It is also possible to connect the clasping ring to a rotor ring of the electric motor by using the band-type brake device as shown cooperatively used with the clasping ring in Fig. 5, thereby braking the rotor. In the robot joint according to the present disclosure, the mounting manner of the band-type brake device in the electric motor is not limited.

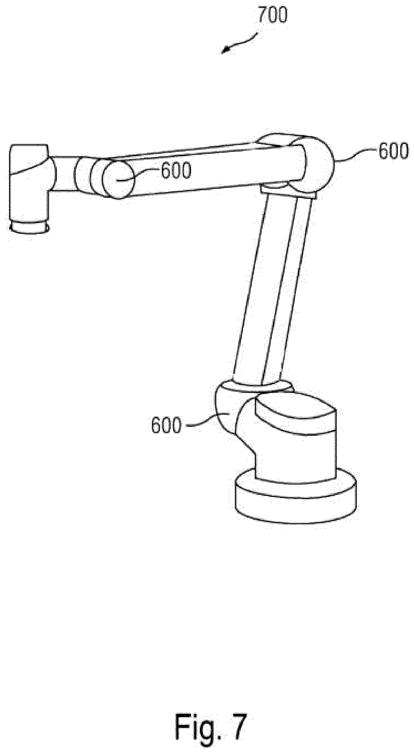

Fig. 7 is a schematic view of a cooperative robot according to an embodiment of the present disclosure. The cooperative robot 700 comprises at least one robot joint 600 according to an embodiment of the present disclosure. The robot joint comprises the band-type brake device according to the embodiment of the present disclosure as described above.

As described above, the band-type brake device according to the present disclosure is braked in the power failure state and released in the electrified state, thus it is a safe braking device. With the cooperative robot provided with the robot joint of the band-type brake device according to the present disclosure, safe braking may be performed in case of an emergency.

A band-type brake device in prior art is a simple on/off band-type brake device without torque control. In order to control the influence of sudden power failure when a band is clasped, a normal friction coupling design is necessary, and the electric motor is movable between two teeth of a band-type brake disc, thus still maintaining the position of the cooperative robot by means of current control of the electric motor.

The electromagnetic band-type brake device in the prior art may achieve accurate band-type brake. However, the electromagnetic band-type brake device is heavy, consumes high power, and does not support accurate torque force control.

The band-type brake device according to the present disclosure and accordingly the cooperative robot including the band-type brake device according to the present disclosure may have the following technical advantages:
the band-type brake device according to the present invention is lighter in weight than the electromagnetic band-type brake device in the prior art, and has accurate control for a band-type brake position. In addition, the band-type brake device according to the present invention has almost zero energy consumption in an operating state, and a torque force may be controlled by means of feedback of a piezoelectric displacement.

Due to the light weight, voltage supply and non-magnetic properties of piezoelectricity, the piezoelectric-based band-type brake device may also have the advantages of being lightweight, low in energy consumption and usable in a non-magnetic environment.

Since the displacement of the piezoceramic stack can be accurately controlled, the piezoelectric-based band-type brake device may achieve accurate torque control as well as wear monitoring and compensation.

Furthermore, since the piezoceramic stack has a high dynamic performance, the band-type brake device according to the present invention may be operated at a high frequency.

The band-type brake device of the embodiment of the present invention may adjust an output stroke by using the displacement adjuster and may adjust an output force to a desired point, so that a good braking effect can be ensured.

In conclusion, the band-type brake device of the present invention has a significant technical advantage over the prior art, and if it is applied to the joint of the cooperative robot, the performance in terms of safety and the like of the cooperative robot product may be enhanced.

Furthermore, the band-type brake device according to the present invention may also be used for a servo motor, is used to replace the current electromagnetic band-type brake device and may achieve high performance and light weight.

Exemplary embodiments are described above in conjunction with the specific embodiments described in the accompanying drawings, but do not represent all the embodiments that can be implemented or fall within the protection scope of the claims. The term "exemplary" used throughout the specification means "used as an example, an instance or an illustration", but does not mean "preferred" or "advantageous" over the other embodiments. For the purpose of providing an understanding of the described technologies, the specific embodiments include specific details. However, the technologies can be implemented without the specific details. In some embodiments, in order to avoid causing any difficulty in the understanding of the described concepts in the embodiments, commonly known structures and devices are shown in the form of a block diagram.

The descriptions above of the present disclosure are provided to enable any person of ordinary skill in the art to implement or use the present disclosure. For those of ordinary skill in the art, various modifications made to the present disclosure are obvious and the general principles defined herein may also be applied to other variants without departing from the protective scope of the present disclosure. Therefore, the present disclosure is not limited to the examples and designs described herein, and corresponds to the widest scope in accordance with the principles and novel features disclosed herein.

## Claims

1. A band-type brake device (100), comprising:
a piezoceramic stack (102), the piezoceramic stack (102) being arranged extending in the direction of a first axis (XX') and provided with a first end (1022) and a second end (1024) in the direction of the first axis (XX'), wherein the first end (1022) and the second end (1024) of the piezoceramic stack (102) extend outwards in the direction of the first axis (XX') when the band-type brake device (100) is in an electrified state, and the first end (1022) and the second end (1024) of the piezoceramic stack (102) contract inwards in the direction of the first axis (XX') when power failure of the band-type brake device (100) occurs;
a displacement adjuster (104), the displacement adjuster (104) being arranged around the piezoceramic stack (102), and the displacement adjuster (104) comprising a first input end (1042) and a second input end (1044) in the direction of the first axis (XX') and a first output end (1046) and a second output end (1048) in the direction of a second axis (YY') perpendicular to the direction of the first axis (XX'); and
at least one friction component (106),
wherein the first end (1022) and the second end (1024) of the piezoceramic stack (102) respectively abut against the first input end (1042) and the second input end (1044) of the displacement adjuster (104), at least one of the first output end (1046) and the second output end (1048) of the displacement adjuster (104) is connected to the at least one friction component (106), or at least one of the first output end (1046) and the second output end (1048) of the displacement adjuster is integrally formed with the at least one friction component (106).

2. The band-type brake device (200) of claim 1, further comprising at least one brake arm (208), with a first end (2082) of the at least one brake arm (208) being connected to at least one of the first output end (2046) and the second output end (2048) of the displacement adjuster (204), and a second end (2084) of the at least one brake arm (208) being connected to the at least one friction component (206).

3. The band-type brake device (100, 200) of any one of claims 1-2, wherein the first input end (1042, 2042) and the second input end (1044, 2042) of the displacement adjuster (104, 204) receive input displacements from the first end (1022, 2022) and the second end (1024, 2024) of the piezoceramic stack (102, 202) and in the direction of the first axis (XX'), and the first output end (1046, 2046) and the second output end (1048, 2048) of the displacement adjuster (104, 204) magnify and output the input displacements in the direction of the second axis (YY').

4. The band-type brake device (100, 200) of claim 3, wherein an outer surface and an inner surface of the displacement adjuster (104, 204) are provided with recesses (301) at appropriate positions to form hinges, such that the displacement adjuster (104, 204) forms a connecting rod mechanism.

5. The band-type brake device (100, 200) of claim 4, wherein the positions, shapes and depths of the recesses (301) are set according to the stress distribution requirements and the rebound stiffness requirements of the displacement adjuster (104, 204).

6. A robot joint (600), comprising a band-type brake device (100, 200) of any one of claims 1-5, the band-type brake device (100, 200) being fitted and mounted to a rotor (6022) of an electric motor (602) in the robot joint (600) for braking the rotor (6022).

7. A cooperative robot (700), comprising at least one robot joint (600) of claim 6.
